# EUROPEAN PATENT APPLICATION

(11) **EP 0 867 776 A2**
(43) Date of publication of application: **30.09.1998**
(21) Application number: 98302174.2
(22) Date of filing: 24.03.1998
(51) Int. Cl.: G03F 9/02

(54) **Exposure method, exposure apparatus and method for making an exposure apparatus**

(30) Priority: 26.03.1997 JP 91461/97
(71) Applicant: NIKON CORPORATION, Tokyo (JP)
(72) Inventor: Yamamoto, Naoyuki, c/o Nikon Corporation, Chiyoda-ku, Tokyo (JP)
(74) Representative: Rackham, Stephen Neil

(57) **Abstract**

In the exposure method of the present invention, prior to loading of a photosensitive substrate on a movable stage, an amount of tilt relative to an image plane with respect to a projection optical system is measured at each of a plurality of positions on the movable stage. The measured amount of tilt is stored as data. After loading of the photosensitive substrate at a predetermined position on the movable stage for exposure, the position of the photosensitive substrate along an optical axis of the projection optical system is detected. Thereafter, a pattern on a mask is transferred to the photosensitive substrate, based on the detected position of the photosensitive substrate and the stored data on the amount of tilt of the movable stage.

## Description

The present invention relates to an exposure method for transferring a pattern formed on a mask through a projection optical system to a photosensitive substrate loaded on a movable stage.

With respect to exposure apparatuses used in producing, for example, semiconductors, in order to transfer a pattern on a mask through a projection optical system to a photosensitive substrate with high accuracy, it is important to correct an amount of tilt of the photosensitive substrate which is provided on a movable stage, relative to an image plane with respect to the projection optical system. In a conventional exposure apparatus, in order to suppress variations in an amount of tilt of the movable stage during movement thereof, a stage-driving surface on which the movable stage is moved is machined with high precision according to the type of exposure apparatus, thereby flattening the stage-driving surface. However, in the above-mentioned conventional exposure apparatus, there is a disadvantage, such that correction of the amount of tilt of the movable stage is dependent on the degree of precision in machining the stage-driving surface, so that an improvement in accuracy of correction of the amount of tilt of the movable stage is limited. Further, due to the need for machining with high precision. production costs of stages become undesirably high.

In order to obviate such disadvantages, various countermeasures have been attempted. For example, Unexamined Japanese Patent Application Public Disclosure No. 5-283310 discloses an exposure method in which the amount of tilt of the surface of photosensitive substrate relative to the image plane with respect to the projection optical system is corrected in a global manner by a so-called EGL (Enhanced Global Leveling) method. In the EGL method, after a photosensitive substrate to be subjected to exposure is loaded on a stage, the amount of tilt (concave and convex) of the surface of the photosensitive substrate relative to the image plane with respect to the projection optical system is measured at a plurality of measurement sites. The amount of tilt of the entire surface of photosensitive substrate is determined statistically from the respective values of measurements at the plurality of measurement sites, and based on the thus determined amount of tilt, the tilt of the surface of photosensitive substrate is corrected.

However, in the above-mentioned EGL method, measurement of the amount of tilt of the entire surface of photosensitive substrate must be conducted by statistic calculations with respect to each photosensitive substrate after loading, so that a throughput becomes low.

In view of the above, the present invention has been made. It is a primary object of the present invention to provide an exposure method in which stages produced at low cost can be used and a high throughput can be achieved.

The foregoing and other objects, features and advantages of the present invention will be apparent from the following detailed description and appended claims taken in connection with accompanying drawings.

According to the present invention, there is provided an exposure method for transferring a pattern formed on a mask through a projection optical system by exposure to a photosensitive substrate loaded on a movable stage, the projection optical system having an optical axis, comprising the steps of: measuring an amount of tilt of the movable stage relative to an image plane with respect to the projection optical system at each of a plurality of positions on the movable stage, prior to loading of a photosensitive substrate at a predetermined position on the movable stage; storing the measured amount of tilt of the movable stage; loading the photosensitive substrate at the predetermined position on the movable stage; detecting a position of the photosensitive substrate on the movable stage along the optical axis of the projection optical system: and
transferring the pattern on the mask by exposure to the photosensitive substrate, based on the detected position of the photosensitive substrate and the stored amount of tilt of the movable stage.

In the above-mentioned exposure method of present invention, the step of measuring the amount of tilt of the movable stage may be conducted at each of a plurality of measurement points which are arranged on the movable stage in the form of intersection points of lines defining segments of a grid. the number of the segments of the grid being defined by the formula m x n in which each of m and n is an integer.

The above-mentioned exposure method of the present invention may further comprise a height adjustment step of adjusting the position of the photosensitive substrate along the optical axis of the projection optical system so that the position of the photosensitive substrate along the optical axis of the projection optical system becomes coincident with an optimum image-forming position with respect to the projection optical system and a tilt correction step of correcting the amount of tilt of the movable stage so that the movable stage becomes in parallel to the image plane with respect to the projection optical system. The height adjustment step and the tilt correction step may be conducted at the same time.

In the exposure method of the present invention in which the amount of tilt of the stage is measured and stored as data prior to loading of the photosensitive substrate on the stage and leveling of the stage is conducted after loading of the photosensitive substrate by reading the stored data, it is unnecessary to conduct measurement of the amount of tilt with respect to each photosensitive substrate or each shot area to be subjected to exposure, so that a high throughput can be achieved. Further, differing from conventional techniques, the accuracy in measurement of the amount of tilt of the stage is not dependent on the degree of precision in machining the stage-driving surface, so that cost of production of stages can be reduced to a low level.

Further, according to the present invention, there is provided an exposure apparatus for transferring a pattern formed on a mask through a projection optical system by exposure to a photosensitive substrate loaded on a stage, the projection optical system having an optical axis, comprising: a measuring device which measures coordinates of a position of the stage in a predetermined plane; a tilt amount measuring device which measures an amount of tilt of the stage relative to an image plane with respect to the projection optical system; a memory which stores the amount of tilt of the stage in association with the coordinates of the position of the stage; a position measuring device which measures a position of a photosensitive substrate loaded on the stage along the optical axis of the projection optical system; and
a driver which moves the stage, based on the position of the photosensitive substrate measured by the position measuring device and the amount of tilt of the stage stored in the memory.

In the exposure apparatus of the present invention, the tilt amount measuring device may measure the amount of tilt of the stage at each of a plurality of predetermined positions to which the stage is moved and the exposure apparatus may further comprise a calculation system which calculates the amount of tilt of the stage at a position different from the plurality of predetermined positions by performing interpolation using the amount of tilt of the stage stored in the memory, when the stage is moved to the position different from the plurality of predetermined positions.

Still further, according to the present invention, there is provided a method for making an exposure apparatus which transfers a pattern formed on a mask through a projection optical system by exposure to a photosensitive substrate loaded on a stage in the presence of illumination light emitted from a light source, comprising: providing a measuring device which measures coordinates of a position of the stage in a predetermined plane; providing a tilt amount measuring device which measures an amount of tilt of the stage relative to an image plane with respect to the projection optical system; providing a memory which stores the amount of tilt of the stage in association with the coordinates of the position of the stage: providing a position measuring device which measures a position of a photosensitive substrate loaded on the stage along the optical axis of the projection optical system; and providing a driver which moves the stage, based on the position of the photosensitive substrate measured by the position measuring device and the amount of tilt of the stage stored in the memory.

Fig. 1 is a general view of a construction of a projection exposure apparatus according to an embodiment of the present invention.

Fig. 2 is a plan view showing an arrangement of an area including a leveling stage in the projection exposure apparatus of Fig. 1.

Fig. 3 is a side view showing the arrangement of the area including the leveling stage in the projection exposure apparatus of Fig. 1.

Fig. 4 is a block diagram showing an arrangement of a control system for leveling and focus adjustment conducted in the embodiment of the present invention.

Fig. 5 is a top view of the leveling stage for explaining an arrangement of measurement points on the leveling stage for leveling in the embodiment of the present invention.

Fig. 6 is a flow chart showing how the exposure method according to the embodiment of the present invention is practiced.

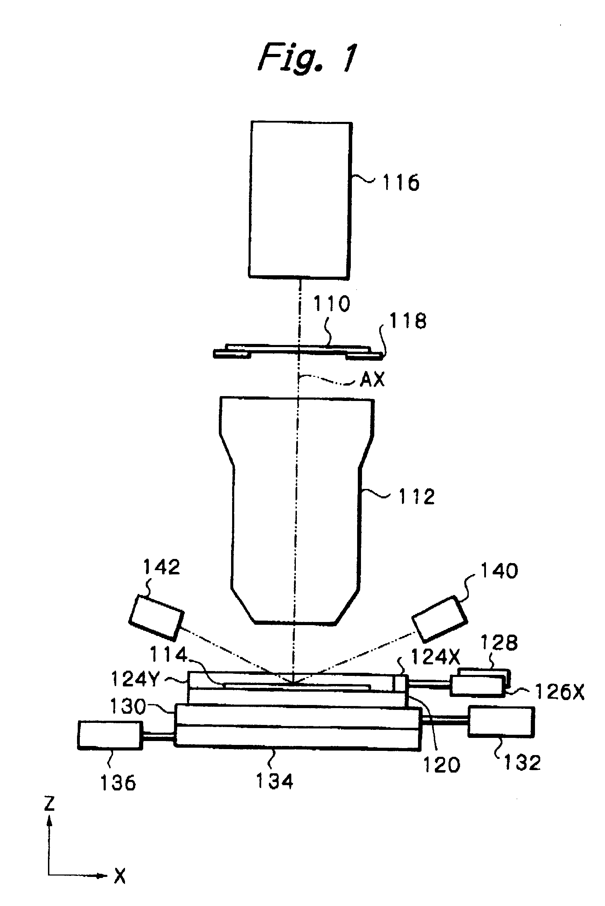

Fig. 1 shows a projection exposure apparatus according to an embodiment of the present invention. In this embodiment, the present invention is applied to a projection exposure apparatus for producing semiconductor devices, in which a pattern formed on a reticle 110 as a mask is transferred through a projection optical system 112 to a wafer 114 as a photosensitive substrate. In the projection exposure apparatus in this embodiment, exposure light exhibiting a uniform illuminance distribution is emitted from an illumination system 116 including a light source and irradiated to the reticle 110 held by a reticle holder 118. The pattern (not shown) to be transferred to the wafer 114 is formed on a lower surface of the reticle 110. An image of the pattern is projected through the projection optical system 112 to the wafer 114 at a predetermined demagnification.

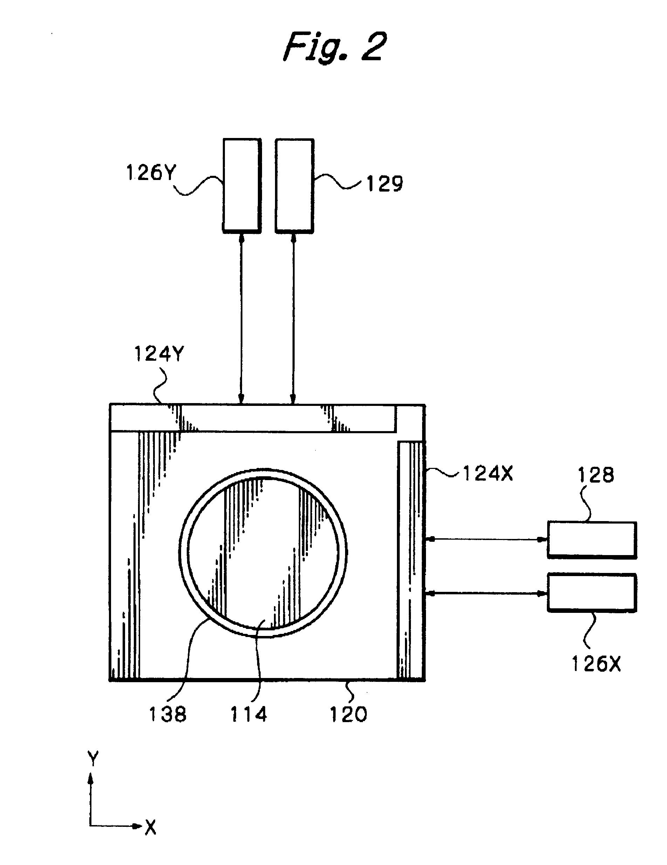

The wafer 114 is held, for example, by suction, by a wafer holder 138 provided on a rectangular leveling stage 120 (see Fig. 2). Movable mirrors 124X and 124Y are provided on the leveling stage 120 along two sides thereof. The movable mirrors 124X and 124Y are adapted to reflect laser beams emitted from laser interferometers 126X and 126Y, respectively (see Fig. 2). The laser interferometer 126X (hereinafter, frequently referred to as "X-axis laser interferometer 126X") is adapted to measure a coordinate of the position of the leveling stage 120 along an X-axis (which extends in a lateral direction in Fig. 1) and the laser interferometer 126Y (hereinafter, frequently referred to as "Y-axis laser interferometer 126Y") is adapted to measure a coordinate of the position of the leveling stage 120 along a Y-axis (which extends in a direction perpendicular to the plane of Fig. 1). The laser interferometers 126X and 126Y are, respectively, adapted to measure the coordinates of the position of the leveling stage 120 along the X-axis and the Y-axis, based on the interference of light reflected by fixed mirrors (not shown), which are fixedly provided in the projection optical system 112, with light reflected by the movable mirrors 124X and 124Y. As explained later, the leveling stage 120 is arranged in a manner such that the adjustment of the position of the wafer 114 along a Z-axis (vertically extending in Fig. 1) in parallel to an optical axis AX of the projection optical system 112 (hereinafter, frequently referred to simply as "focus adjustment") and correction of the amount of tilt of the leveling stage 120 (hereinafter, frequently referred to simply as "leveling") can be performed.

The leveling stage 120 is provided on an X-stage 130 which is capable of being moved in a direction of the X-axis (hereinafter, referred to simply as "X-direction") by an X-stage drive system 132. The X-stage 130 is provided on a Y-stage 134 which is capable of being moved in a direction of the Y-axis (hereinafter, referred to simply as "Y-direction") by a Y-stage drive system 136. A light emitting system 140 and a light receiving system 142, both constituting an oblique incidence type autofocus device, are provided at both sides of the projection optical system 112. A light beam having a slit-shaped cross-section is obliquely irradiated from the light emitting system 140 to the surface of the wafer 114 and reflected by the surface of the wafer 114. The reflected light beam is detected by the light receiving system 142. Using this autofocus device (comprising the light emitting system 140 and the light receiving system 142), the position of the surface of wafer 114 along the optical axis AX of the projection optical system 112 (the Z-axis) can be measured.

Next, referring to Fig. 2, explanation is made on an arrangement of an area including the leveling stage 120 in the projection exposure apparatus of Fig. 1. As is also shown in Fig. 1, a collimator 128 is disposed at a side of the X-axis laser interferometer 126X and a collimator 129 is disposed at a side of the Y-axis laser interferometer 126Y. The collimator 128 is adapted to emit light for measurement to the movable mirror 124X and measures the amount of tilt (tilt angle) of the leveling stage 120 in the X-direction, based on the light reflected by the movable mirror 124X. The collimator 129 is adapted to emit light for measurement to the movable mirror 124Y and measures the amount of tilt (tilt angle) of the leveling stage 120 in the Y-direction, based on the light reflected by the movable mirror 124Y. The measurements of amounts of tilt of the leveling stage 120 in the X-direction and the Y-direction (hereinafter, frequently referred to simply as "measurement of the amount of tilt of the leveling stage 120") are preliminarily conducted prior to loading of the wafer 114 on the leveling stage 120, that is, prior to exposure.

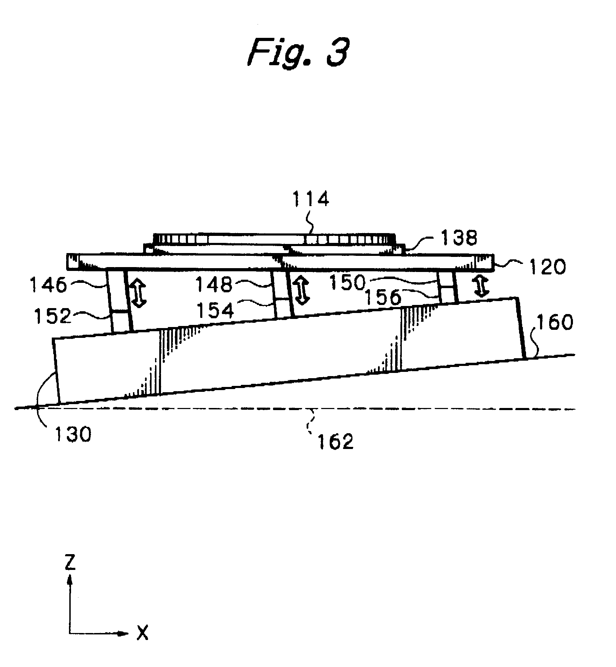

Fig. 3 shows an arrangement of a drive system for the leveling stage 120. 3 Direct-current motors (DC motors) 146, 148 and 150 are provided between the leveling stage 120 and the X-stage 130. Each of the DC motors 146, 148 and 150 is adapted to move the leveling stage 120 in a direction parallel to the optical axis AX of the projection optical system 112 (Z-direction). The DC motors 146, 148 and 150 are connected to encoders 152, 154 and 156, respectively, which are capable of monitoring amounts of rotation of the DC motors 146, 148 and 150. That is, the amount by which the leveling stage 120 is moved by the DC motors 146, 148 and 150 can be monitored, based on detection values of the encoders 152, 154 and 156. In this embodiment of the present invention, the DC motors 146, 148 and 150 are capable of being individually controlled and not only correction of the amount of tilt of the leveling stage 120 (leveling), but also adjustment of the position of the wafer 114 along the Z-axis (focus adjustment) can be conducted. Incidentally, reference numerals 162 and 160, respectively, denote an ideal stage-driving surface for the X-stage 130 (or the leveling stage 120), which is an image plane with respect to the projection optical system 112, and an actual stage-driving surface for the X-stage 130 (or the leveling stage 120). In Fig. 3, the actual stage-driving surface 160 for the X-stage 130 is tilted at an extremely large angle, relative to the ideal stage-driving surface 162. The stage-driving surface 160 for the X-stage 130 is the surface of the Y-stage 134 (see Fig. 1) which is tilted relative to the ideal stage-driving surface 162 for various reasons, such as poor machining accuracy.

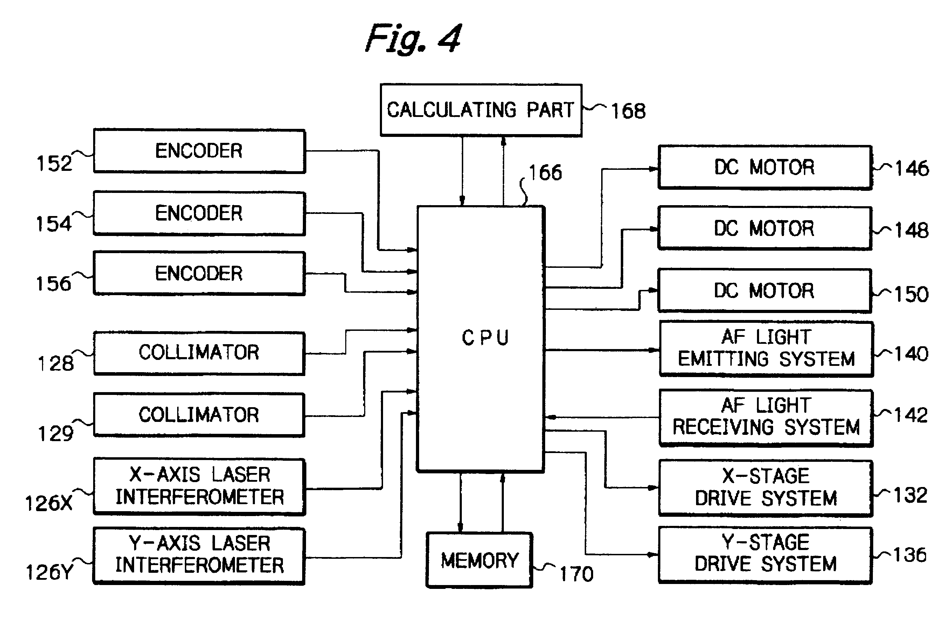

Hereinbelow, an arrangement of a control system for leveling and focus adjustment in this embodiment is explained, with reference to Fig. 4. Reference numeral 166 denotes a CPU (central processing unit) adapted to comprehensively control the entire control system. The CPU 166 is connected to a calculating part 168 adapted to conduct predetermined calculations and a memory 170 adapted to store data with respect to the amount of tilt of the leveling stage 120. As mentioned above, the amounts of rotation of the DC motors 146, 148 and 150 are detected by the encoders 152, 154 and 156. Data with respect to the detected amounts of rotation of these DC motors is supplied from the encoders 152, 154 and 156 to the CPU 166. Data with respect to the position of the surface of wafer 114 along the Z-axis (data on height of the wafer 114) is supplied from the light receiving system 142 of the autofocus device (comprising the light emitting system 140 and the light receiving system 142) to the CPU 166. Data with respect to the amount of tilt of the leveling stage 120 is supplied from the collimators 128 and 129 to the CPU 166. Data with respect to the coordinates of the position of the leveling stage 120 in the X-Y plane is supplied from the X-axis laser interferometer 126X and the Y-axis laser interferometer 126Y to the CPU 166.

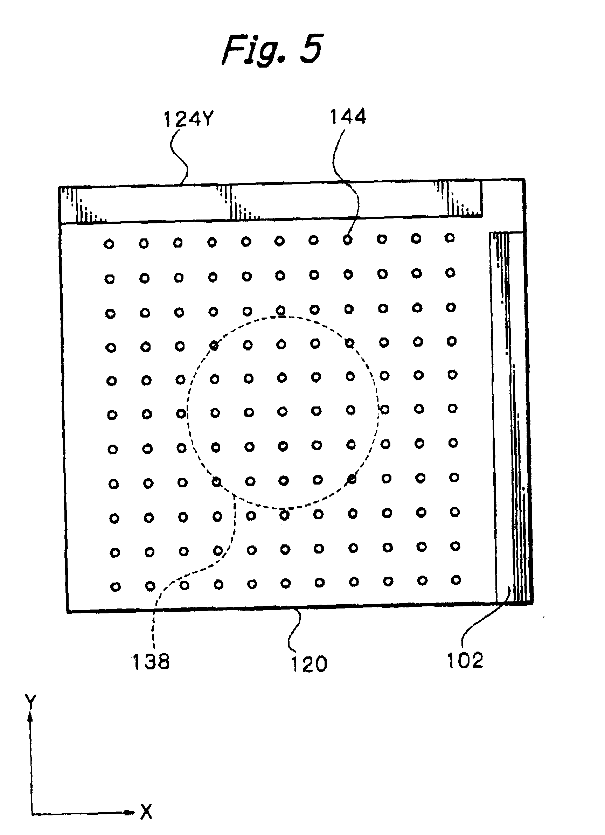

The CPU 166 stores, as map data, respective amounts of tilt at a plurality of positions on the leveling stage 120 in the memory 170, based on data supplied from the collimators 128 and 129 and the laser interferometers 126X and 126Y. With respect to measurement points for measurement of the amount of tilt of the leveling stage 120, for example, as shown in Fig. 5, measurement of the amount of tilt may be conducted with respect to each of a plurality of points 144, which are arranged on the leveling stage 120 in the form of intersection points of lines defining segments of a grid, in a region where the leveling stage 120 is capable of being moved. The number of segments of the grid on the leveling stage 120 is represented by the formula m x n, wherein each of m and n is an integer. In Fig. 5, the number of segments of the grid on the leveling stage 120 is (10 x 10). Prior to exposure, the amount of tilt may be measured with respect to each of these measurement points 144 on the leveling stage 120 by using the collimators 128 and 129. In the present invention, the number of segments of the grid on the leveling stage 120 is not limited to (10 x 10) and can be changed as desired. The positions of measurement points can also be changed.

When the wafer 114 is loaded on the leveling stage 120 for exposure, with respect to each shot area on the wafer 114, the CPU 166 reads data on the amount of tilt stored in the memory 170 and controls the calculating part 168 to calculate a tilt correction amount for the leveling stage 120 (the amount by which each of the DC motors is to be rotated for correcting the amount of tilt of the leveling stage 120) and while making reference to data from the encoders 152, 154 and 156, the CPU 166 rotates the DC motors 146, 148 and 150, to thereby correct the amount of tilt of the leveling stage 120. Further, the CPU 166 performs focus adjustment (adjustment of the height of wafer 114) by rotating the DC motors 146, 148 and 150, based on data with respect to a focus position (position of the wafer 114 along the Z-axis)from the light receiving system 142 of the autofocus device. That is, the CPU 166 enables an exposure surface of the wafer 114 to be located at an optimum image-forming position with respect to the projection optical system 112.

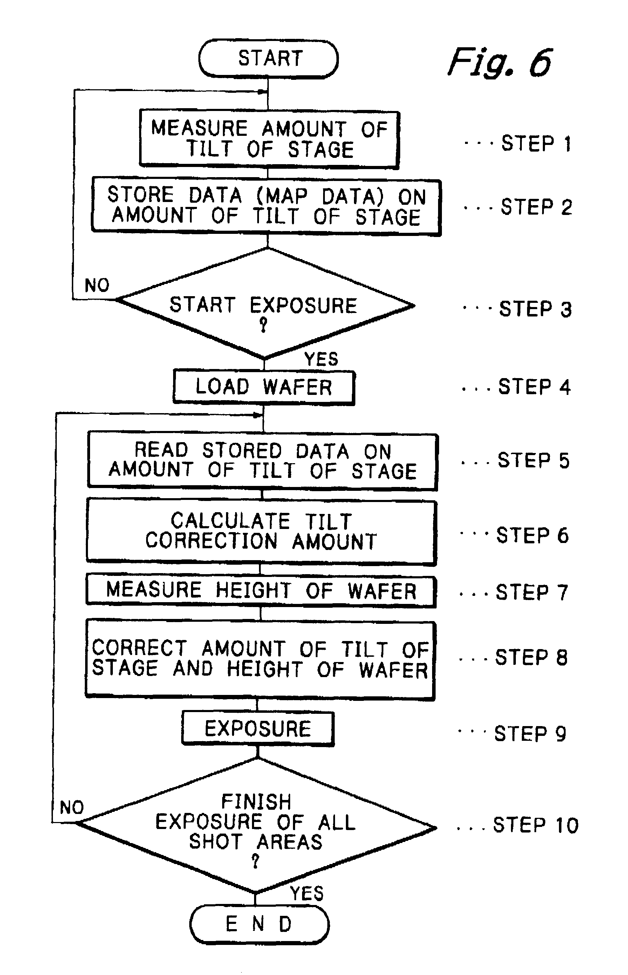

Next, how the exposure method according to this embodiment of the present invention is practiced is explained, in accordance with a flow chart in Fig. 6. Prior to loading of the wafer 114 on the wafer holder 138, in a step 1, measurement is conducted with respect to the amount of tilt of the leveling stage 120. In this instance, the X-stage drive system 132 and the Y-stage drive system 136 drive the leveling stage 120 in the X-Y plane. based on data with respect to the coordinates of the position of the leveling stage 120 from the X-axis laser interferometer 126X and the Y-axis laser interferometer 126Y and data on the respective positions of measurement points 144 arranged on the leveling stage 120 in the form of intersection points of lines defining segments [number: m x n (each of m and n is an integer)] of a grid, which data has been preliminarily stored in the memory 170. Illustratively stated, the CPU 166 controls the X-stage drive system 132 and the Y-stage drive system 136 to move the leveling stage 120 so that the measurement points 144 on the leveling stage 120 are successively moved to a position for exposure on the optical axis AX of the projection optical system 112, and with respect to each measurement point 144 positioned on the optical axis AX of the projection optical system 112, the amounts of tilt in the X-direction and the Y-direction are measured by the collimator 128 and the collimator 129, respectively. In a step 2, the CPU 166 stores, as map data, the respective amounts of tilt at the measurement points 144 on the leveling stage 120 in the memory 170, based on data from the collimators 128 and 129.

Subsequently, when it is determined to conduct exposure (step 3), the wafer 114 is loaded on the wafer holder 138 on the leveling stage 120 (step 4). Then, the center of one shot area (area for exposure) on the wafer 114 is moved to the position for exposure on the optical axis AX of the projection optical system 112. In a step 5, the CPU 166 reads data on the amount of tilt stored in the memory 170. In a step 6, the CPU 166 controls the calculating part 168 to calculate the tilt correction amount for the leveling stage 120 with respect to the shot area with its center being located at the position for exposure. With respect to calculation of the tilt correction amount for the leveling stage 120, because the positions of measurement points 144 in Fig. 5 may not coincide with the centers of the shot areas on the wafer 114, the tilt correction amount for the leveling stage 120 with respect to one shot area is calculated by, for example, determining an average value of the amounts of tilt at a plurality of measurement points in the vicinity of the center of that shot area.

In a step 7, the CPU 166 actuates the light emitting system 140 and the light receiving system 142 of the autofocus device, to thereby detect the position of the wafer 114 along the Z-axis with respect to the shot area with its center being located at the position for exposure. The calculating part 168 calculates a correction amount for the position of the leveling stage 120 along the Z-axis (focus control amount), based on a signal from the light receiving system 142 of the autofocus device. Thereafter, while making reference to data supplied from the encoders 152, 154 and 156 through the CPU 166, the calculating part 168 calculates the amount by which each of the DC motors 146, 148 and 150 is to be rotated (amount of rotation of each of the DC motors 146, 148 and 150), based on the tilt correction amount and the correction amount for the position of the leveling stage 120 along the Z-axis.

In a step 8, the CPU 166 controls rotation of each of the DC motors 146, 148 and 150, based on the amount of rotation of each of the DC motors 146, 148 and 150 calculated by the CPU 166, so that adjustment of the position of the leveling stage 120 is conducted at three points at which the DC motors 146, 148 and 150 are provided, to thereby perform focus adjustment and leveling. That is, in the step 8, the CPU 166 enables the leveling stage 120 to become in parallel to the image plane with respect to the projection optical system 112 and also enables the position of exposure surface of the wafer 114 to become coincident with the optimum image-forming position with respect to the projection optical system 112. Then, in a step 9, the pattern on the reticle 110 is transferred through the projection optical system 112 to the shot area with respect to which leveling and focus adjustment have been conducted in the above-mentioned manner. Subsequently, the above-mentioned operations in the steps 5 to 9 are conducted with respect to each of the remaining shot areas on the wafer 114. When it is determined that exposure has been conducted with respect to all shot areas on the wafer 114 (step 10), the wafer 114 is unloaded from the leveling stage 120. Incidentally, correction of the amount of tilt of the leveling stage 120 (leveling) and adjustment of the height of wafer 114 (focus adjustment) may not be necessarily conducted at the same time. The leveling and the focus adjustment may be conducted in a manner such that when one of these operations is finished, the other operation is conducted.

The exposure apparatus used in this embodiment of the present invention is assembled by electrically, mechanically and optically connecting elements capable of constituting an exposure apparatus which exerts the above-mentioned functions of leveling and focus adjustment in accordance with the exposure method of the present invention.

As mentioned above, the exposure method of the present invention is advantageous in that stages produced at low cost can be used and a high throughput can be achieved. Differing from conventional techniques, in the present invention, the accuracy in measurement of the amount of tilt of the stage is not dependent on the degree of precision in machining the stage-driving surface, so that cost of production of stages can be reduced to a low level. Further, because the amount of tilt of the stage is measured and stored as data prior to loading of the photosensitive substrate on the stage and leveling of the stage is conducted after loading of the photosensitive substrate by reading the stored data, it is unnecessary to conduct measurement of the amount of tilt with respect to each photosensitive substrate or each shot area to be subjected to exposure, so that a high throughput can be achieved.

Hereinabove, the embodiment of the present invention has been described. However, the present invention is not limited to the above-mentioned embodiment. Various modifications are possible without departing from the scope of the present invention as defined in the appended claims.

## Claims

1. An exposure method for transferring a pattern formed on a mask through a projection optical system to a photosensitive substrate loaded on a movable stage, said projection optical system having an optical axis, comprising the steps of:
measuring an amount of tilt of said movable stage relative to an image plane with respect to said projection optical system at each of a plurality of positions on said movable stage, prior to loading of a photosensitive substrate at a predetermined position on said movable stage;
storing said measured amount of tilt of the movable stage;
loading said photosensitive substrate at the predetermined position on said movable stage;
detecting a position of said photosensitive substrate on said movable stage along the optical axis of said projection optical system; and
transferring said pattern on the mask to said photosensitive substrate, based on said detected position of the photosensitive substrate and said stored amount of tilt of the movable stage.

2. An exposure method according to claim 1, wherein said step of measuring the amount of tilt of said movable stage is conducted at each of a plurality of measurement points which are arranged on said movable stage in the form of intersection points of lines defining segments of a grid, the number of said segments of the grid being defined by the formula m x n in which each of m and n is an integer.

3. An exposure method according to claim 1. wherein said step of measuring the amount of tilt of said movable stage is conducted in a region where said movable stage is capable of being moved.

4. An exposure method according to claim 1, further comprising a step of correcting said amount of tilt of the movable stage prior to transferring of said pattern on the mask to said photosensitive substrate.

5. An exposure method according to claim 1, further comprising a height adjustment step of adjusting said position of the photosensitive substrate along the optical axis of said projection optical system so that said position of the photosensitive substrate along the optical axis of said projection optical system becomes coincident with an image-forming position with respect to said projection optical system and a tilt correction step of correcting said amount of tilt of the movable stage so that said movable stage becomes in parallel to the image plane with respect to said projection optical system.

6. An exposure method according to claim 5, wherein said height adjustment step and said tilt correction step are conducted at the same time.

7. An exposure apparatus for transferring a pattern formed on a mask through a projection optical system to a photosensitive substrate loaded on a stage, said projection optical system having an optical axis, comprising:
a measuring device which measures coordinates of a position of said stage in a predetermined plane;
a tilt amount measuring device which measures an amount of tilt of said stage relative to an image plane with respect to said projection optical system;
a memory which stores said amount of tilt of the stage in association with said coordinates of the position of the stage;
a position measuring device which measures a position of a photosensitive substrate loaded on said stage along the optical axis of said projection optical system; and
a driver which moves said stage, based on said position of the photosensitive substrate measured by said position measuring device and said amount of tilt of the stage stored in said memory.

8. An exposure apparatus according to claim 7, wherein said tilt amount measuring device measures said amount of tilt of the stage at each of a plurality of predetermined positions to which said stage is moved and said exposure apparatus further comprises a calculation system which calculates said amount of tilt of the stage at a position different from the plurality of predetermined positions by performing interpolation using said amount of tilt of the stage stored in said memory, when said stage is moved to said position different from the plurality of predetermined positions.

9. A method for making an exposure apparatus which transfers a pattern formed on a mask through a projection optical system to a photosensitive substrate loaded on a stage comprising:
providing a measuring device which measures coordinates of a position of said stage in a predetermined plane;
providing a tilt amount measuring device which measures an amount of tilt of said stage relative to an image plane with respect to said projection optical system;
providing a memory which stores said amount of tilt of the stage in association with said coordinates of the position of the stage;
providing a position measuring device which measures a position of a photosensitive substrate loaded on said stage along an optical axis of said projection optical system; and
providing a driver which moves said stage, based on said position of the photosensitive substrate measured by said position measuring device and said amount of tilt of the stage stored in said memory.
